(19) Europäisches Patentamt
European Patent Office
Office européen des brevets

(11) **EP 4 195 434 B1**

(12) **EUROPÄISCHE PATENTSCHRIFT**

(45) Veröffentlichungstag und Bekanntmachung des Hinweises auf die Patenterteilung:
**29.04.2026   Patentblatt 2026/18**

(21) Anmeldenummer: **22211308.6**

(22) Anmeldetag: **05.12.2022**

(51) Internationale Patentklassifikation (IPC):
**H02H 5/12** *(2006.01)*       **H02H 3/16** *(2006.01)*
**G01R 27/18** *(2006.01)*

(52) Gemeinsame Patentklassifikation (CPC):
**H02H 5/12; G01R 27/16; G01R 27/18; G01R 31/52;**
H02H 3/162

(54) **VERFAHREN UND EINRICHTUNG ZUR IMPEDANZÜBERWACHUNG ZUM SCHUTZ GEGEN ELEKTRISCHEN SCHLAG**

METHOD AND DEVICE FOR IMPEDANCE MONITORING FOR PROTECTION AGAINST ELECTRICAL SHOCKS

PROCÉDÉ ET DISPOSITIF DE SURVEILLANCE DE L'IMPÉDANCE POUR LA PROTECTION CONTRE LES CHOCS ÉLECTRIQUES

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität:  **07.12.2021   DE 102021132161**

(43) Veröffentlichungstag der Anmeldung:
**14.06.2023   Patentblatt 2023/24**

(73) Patentinhaber: **Bender GmbH & Co. KG**
**35305 Grünberg (DE)**

(72) Erfinder:
• **HAUB, Dennis**
**35428 Langgöns (DE)**
• **HOFHEINZ, Wolfgang**
**35305 Grünberg (DE)**

(74) Vertreter: **advotec.**
**Patent- und Rechtsanwaltspartnerschaft mbB**
**Georg-Schlosser-Straße 6**
**35390 Gießen (DE)**

(56) Entgegenhaltungen:
**EP-A1- 3 598 151     DE-A1- 102014 204 038**
**US-B2- 7 538 454**

**Beschreibung**

Die Erfindung betrifft ein Verfahren und eine Einrichtung zur Impedanzüberwachung für ein ein- oder mehrphasiges ungeerdetes Stromversorgungssystem.

Im Rahmen der Sicherheitsgrundnorm VDE 0100-410 sowie der international entsprechenden Norm IEC 60364-4-41 werden Schutzmaßnahmen (Schutz gegen elektrischen Schlag) in einem ungeerdeten Stromversorgungssystem festgelegt.

Das ungeerdete Stromversorgungssystem wird auch als isoliertes Netz (französisch isolée terre - IT) oder als IT-System bezeichnet. Bei dieser Art des Stromversorgungssystems sind die aktiven Teile von dem Erdpotential - gegenüber Erde - getrennt. Der Vorteil dieser Netze liegt darin, dass bei einem Isolationsfehler (erster (Isolations-)Fehler), wie beispielsweise einem Erdschluss (leitende Verbindung zwischen einem spannungsführenden, aktiven Leiter und Erde) oder einem Körperschluss (leitende Verbindung zwischen einem spannungsführenden, aktiven Leiter und dem Körper oder Gehäuse eines Verbrauchers oder Betriebsmittels), die Funktion der angeschlossenen elektrischen Verbraucher nicht beeinträchtigt wird, da deren Körper getrennt von den aktiven Leitern des IT-Systems einzeln oder gemeinsam über einen Schutzleiter geerdet sind und sich somit wegen des im Idealfall - Netzableitkapazitäten seien dabei vernachlässigt - unendlich großen Impedanzwertes zwischen einem aktiven Leiter des Netzes und Erde kein geschlossener Stromkreis ausbilden kann.

Durch diese inhärente Sicherheit des ungeerdeten Stromversorgungssystems kann somit eine kontinuierliche Stromversorgung der von dem ungeerdeten Stromversorgungssystem gespeisten Verbraucher auch dann gewährleistet werden, wenn ein erster Isolationsfehler auftritt.

Der Widerstand des ungeerdeten Stromversorgungssystems gegen Erde (Isolationswiderstand - im Fehlerfall auch Isolationsfehlerwiderstand oder Fehlerwiderstand) wird daher ständig überwacht, da durch einen möglichen weiteren Fehler, beispielsweise einem weiteren Erdschluss, Körperschluss oder durch menschliche Berührung, an einem anderen aktiven Leiter (zweiter (Isolations-)Fehler) eine Fehlerschleife über den Schutzleiter entstünde und der dabei fließende Fehlerstrom in Verbindung mit einer Überstromschutzeinrichtung eine Abschaltung der Anlage mit Betriebsstillstand zur Folge hätte.

Mit dem Schutz gegen elektrischen Schlag soll verhindert werden, dass ein gefährlicher elektrischer Strom durch den menschlichen Körper (Personenschutz) oder den Körper eines Tieres fließt. Die oben zitierte Norm schließt den Fall der Berührung eines aktiven Leiters (direktes Berühren) in dem ungeerdeten Stromversorgungssystems nach Versagen der Basisisolierung nicht aus, wobei allerdings das ungeerdete Stromversorgungssystem nur in Zusammenhang mit der Schutzmaßnahme "automatische Abschaltung der Stromversorgung unter Annahme von zwei widerstandslosen Isolationsfehlern an unterschiedlichen aktiven Leitern" betrachtet wird.

Voraussetzung der nach oben genannten Normen vorgeschriebenen Schutzwirkungen ist, dass die Körper der angeschlossenen Verbraucher mit leitfähigem Gehäuse (Betriebsmittel der Schutzklasse 1) niederohmig mit dem Schutzleiter verbunden sind und der Schutz bei Berühren beispielsweise eines Gerätegehäuses (indirektes Berühren) nach einem Körper oder Erdschluss (erster Fehler) und nach einem weiteren widerstandslosen Isolationsfehler an einem anderen aktiven Leiter (zweiter Fehler) zur automatischen Abschaltung durch eine dafür vorgesehene Überstromschutzeinrichtung sichergestellt wird.

Aus dem Stand der Technik ist es bekannt, die ständige Überwachung des Isolationswiderstands mit einem Isolationsüberwachungsgerät gemäß der Produktnorm IEC 61557-8 durchzuführen, wobei allerdings, wie oben dargestellt, die Isolationsüberwachung nur bezüglich der indirekten Berührung des Betriebsmittels im ungeerdeten Stromversorgungssystem bei intaktem Schutzleiter erfolgt. Auch die weiteren bekannten Verfahren zur Bestimmung des Isolationswiderstands gehen von einer funktionsfähigen Schutzleiterverbindung der Betriebsmittel aus.

So zeigt die Offenlegungsschrift DE 10 2014 204 038 A1 ein Verfahren zur Isolationsüberwachung eines ungeerdeten Stromversorgungssystems, wobei eine separate Bestimmung des Isolationswiderstandes für jeden Phasenleiter erfolgt.

Die Offenlegungsschrift EP 3 832 324 A1 zeigt ebenfalls eine Schaltungsanordnung zur Bestimmung eines Isolationswiderstands in einem ungeerdeten Stromversorgungssystem, wobei eine leiterselektive Bestimmung aus einer komplexwertigen Isolationsimpedanz möglich ist, allerdings nur für abgeschaltete Teile des ungeerdeten Stromversorgungssystems.

Weiter zeigt die Offenlegungsschrift EP 3 598 151 A1 die phasenselektive Aufteilung eines Gesamtisolationswiderstands und einer Gesamtnetzableitkapazität in einem ungeerdeten Stromversorgungssystem.

Die Patentschrift EP 0 061 704 B1 zeigt ein Verfahren zur Bestimmung der Gesamtableitimpedanz sowie des hieraus herleitbaren maximalen Leiterberührstroms in einem ungeerdeten Wechselspannungs-Stromversorgungssystem.

Die US-Patentschrift US 7,538,454 B2 beschreibt die Ableitung von Fehlerströmen in Halbleiterschaltkreisen, die vorzugsweise in Schutzschaltern Verwendung finden. Ein elektrisches RC-Schaltkreismodell für den menschlichen Körper wird dabei als Simulationsmodell zur Verifikation zugrunde gelegt.

Bei dem vorgenannten zitierten Stand der Technik erweist es sich als nachteilig, dass mögliche gefährdende Körperströme sowie mögliche Unterbrechungen des Schutzleiters nicht oder nur als Simulationsmodell zur Verifikation in Betracht gezogen werden.

Es fehlen darüber hinaus normative Anforderungen für den Fall der Berührung eines aktiven ungeerdeten Leiters nach dem Versagen der Basisisolierung und bei gleichzeitigem Verlust des Schutzleiters, beispielsweise durch eine Unterbrechung oder Abriss oder im allgemeinen Fall der Hochohmigkeit.

Auch fehlen Vorschriften für ungeerdete Stromversorgungssysteme, bei denen sowohl das Stromversorgungssystem als auch die Körper der angeschlossenen Verbraucher ungeerdet sind. Ein solches ungeerdetes Stromversorgungssystem soll zukünftig als II-System (französisch isolée-isolée - II) in die nationale und internationale Normung eingebracht werden.

Die die Erfindung betreffenden Überlegungen gelten damit sowohl für ein ungeerdetes Stromversorgungssystem in Form des IT-Systems, als auch für ein künftiges ungeerdetes Stromversorgungssystem in Form des II-Systems.

Der vorliegenden Erfindung liegt somit die Aufgabe zugrunde, zum Schutz gegen elektrischen Schlag (Personenschutz) für ein ungeerdetes Stromversorgungssystem (IT- und II-System) ein Verfahren und eine Einrichtung vorzuschlagen, die auch bei unterbrochenem oder nicht vorhandenem Schutzleiter wirksam sind.

Diese Aufgabe wird durch ein Verfahren zur Impedanzüberwachung für ein ein- oder mehrphasiges, ungeerdetes Stromversorgungssystem mit einer Stromquelle, aktiven Leitern und einem Verbraucher, mit folgenden Verfahrensschritten gemäss Anspruch 1 gelöst: Messen einer komplexen Impedanz gegenüber Erde gleichzeitig für jeden aktiven Leiter mittels einer Messeinrichtung, mittels einer Recheneinheit Berechnen eines komplexen Berührungsstroms für jeden aktiven Leiter, der nach Auftreten eines ersten Isolationsfehlers an einem der aktiven Leiter (L1, L2, L3) bei einer Berührung eines anderen aktiven Leiters (L1, L2, L3) fließen würde, als Quotient aus einer Leiter-Erde-Spannung des jeweiligen Leiters und einer komplexen Gesamtimpedanz (Zges), die sich aus einer Kombination aus Parallelschaltung und Reihenschaltung der komplexen Impedanzen ergibt, wobei eine Gesamtkörperimpedanz zu der komplexen Impedanz desjenigen aktiven Leiters parallel geschaltet wird, der durch den Mensch berührt wird, Prüfen in der Recheneinheit, ob der jeweilige komplexe Berührungsstrom einen einstellbaren Körperstrom-Schwellwert überschreitet, Erzeugen eines Schaltsignals in der Recheneinheit bei einer Überschreitung des Körperstrom-Schwellwertes, Ansteuern eines Schaltgliedes mit dem Schaltsignal zum Abschalten oder Trennen der Stromquelle.

Der Grundgedanke des erfindungsgemäßen Verfahrens beruht darauf, in dem zu überwachenden ungeerdeten Stromversorgungssystem zunächst leiterselektiv die jeweilige komplexe Impedanz gegenüber Erde zu bestimmen, daraus mittels einer Gesamtkörperimpedanz eines einstellbaren Körperstrommodells einen komplexen Berührungsstrom abzuleiten, der fließen würde, wenn eine Berührung eines anderen Leiters (zweiter Isolationsfehler) durch eine Person stattfinden würde. Falls dieser im Falle einer Berührung fließende komplexe Berührungsstrom einen einstellbaren, personengefährdenden Körperstrom-Schwellenwert überschreitet, wird die den Versorgungsstrom treibende Stromquelle abgeschaltet oder getrennt.

Dazu wird zunächst mittels einer Messeinrichtung, die für jeden aktiven Leiter einen Ankopplungszweig aufweist, gleichzeitig für jeden aktiven Leiter die komplexe Impedanz gegenüber Erde gemessen. Die komplexe Impedanz entspricht dem komplexwertigen Isolationswiderstand des jeweiligen aktiven Leiters des ungeerdeten Stromversorgungssystems und setzt sich zusammen aus dem durch den (reellen) Isolationswiderstand gebildeten Realteil und dem im Wesentlichen durch die Ableitkapazitäten bestimmten kapazitiven Imaginärteil.

Der komplexe Berührungsstrom ergibt sich als Quotient aus der Leiter-Erde-Spannung des jeweiligen Leiters und einer Kombination aus Parallelschaltung und Reihenschaltung der komplexen Impedanzen. Unter Verwendung eines im Gerät hinterlegten Körperstrommodells mit einstellbaren Körperimpedanzwerten wird die Gesamtkörperimpedanz (des menschlichen Körpers) bei der Berechnung eines komplexen Berührungsstroms für jeden aktiven Leiter in der Weise berücksichtigt, dass die komplexe Impedanz des von dem Menschen berührten Leiters um die Gesamtkörperimpedanz verringert wird.

Anschließend erfolgt das Prüfen des jeweiligen, dem entsprechenden aktiven Leiter zugeordneten, komplexen Berührungsstroms in der Recheneinheit daraufhin, ob dieser im Falle einer Berührung - mit der zuvor eingestellten Gesamtkörperimpedanz - einen einstellbaren Körperstrom-Schwellwert überschreitet. Körperstrom-Schwellwerte markieren die Grenze zwischen für den Menschen unterschiedlich gefährlichen physiologischen Wirkungen bei einer Körperdurchströmung.

Wird eine Überschreitung des Körperstrom-Schwellwertes erkannt, so erzeugt die Recheneinheit ein Schaltsignal.

Das Schaltsignal steuert ein Schaltglied an, um eine Abschaltung oder eine Trennung der Stromquelle vorzunehmen.

Im Unterschied zu aus dem Stand der Technik bekannten Verfahren zur Isolationsüberwachung wird nicht der ermittelte Isolationswiderstand, sondern der Wert eines komplexen Berührungsstroms als Kriterium für das Erkennen einer Personengefährdung herangezogen.

Das erfindungsgemäße Verfahren kann somit in folgenden Fällen als Überwachungs- und Schutzeinrichtung in Verbindung mit einem Schaltglied ohne oder mit trennenden Eigenschaften eingesetzt werden:

    a) im Fall der indirekten Berührung eines unter Spannung stehenden Körpers eines Betriebsmittels der Schutzklasse 1 (Schutzmaßnahme mit Schutzleiter) bei unterbrochenem Schutzleiter im IT-System,

b) im Fall der direkten Berührung eines aktiven Leiters bei unterbrochenem Schutzleiter in einem IT-System,

c) im Fall der indirekten Berührung eines unter Spannung stehenden Körpers in einem II-System und

d) im Fall der direkten Berührung eines aktiven Leiters in einem II-System.

Eine auf diesem Verfahren aufbauende Impedanzmesstechnik erhöht den Personenschutz in ungeerdeten Stromversorgungssystemen signifikant.

In einer vorteilhaften Ausgestaltung wird der Körperstrom-Schwellwert einer implementierten Strom-Zeit-Kennlinie entnommen, welche eine Dauer des Körperstroms über der Höhe des Körperstroms darstellt.

In der Strom-Zeit-Kennlinie werden möglichen Körperstrom-Schwellwerten maximal zulässige Durchströmungsdauern (Dauer des Körperstroms) zugeordnet. Die Strom-Zeit-Kennlinie definiert damit eine Grenzlinie zwischen unterschiedlich gefährlichen physiologischen Wirkungen bei einer Körperdurchströmung. Die maximale Zeitspanne, in der eine Abschaltung oder Trennung nach Feststellen der Körperstrom-SchwellwertÜberschreitung erfolgt (Auslösezeit), ergibt sich aus der durch die Strom-Zeit-Kennlinie vorgegebenen Durchströmungsdauer, sodass bei einer Abschaltung/-Trennung der Stromquelle innerhalb dieser Zeitspanne eine personengefährdende Wirkung nicht eintritt. Da durch das erfindungsgemäße Verfahren die Abschaltung oder Trennung präventiv, d.h. vor dem Auftreten des gefährlichen komplexen Berührungsstroms erfolgt, werden die geforderten Auslösezeiten implizit eingehalten.

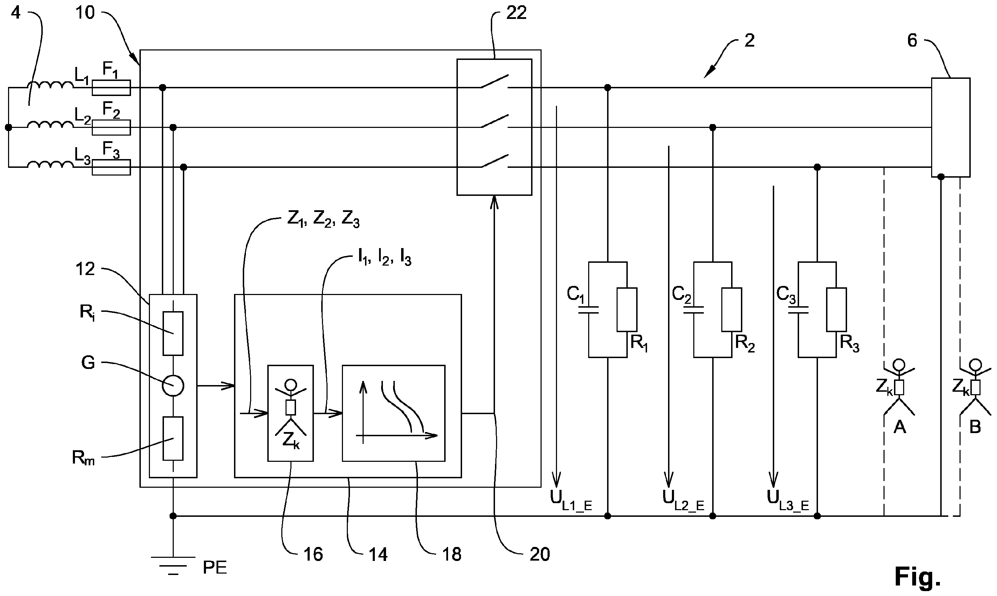

Bevorzugt wird als Strom-Zeit-Kennlinie einer der in der Norm IEC 60479-1 in Fig. 20 dargestellte Verläufe verwendet.

Auf Basis der in dem internationalen Standard IEC-60479-1:2018 beschriebenen Strom-Zeit-Kennlinien kann der personengefährdende, einstellbare Körperstromschwellwert, bei dem eine Abschaltung oder Trennung der Stromquelle erfolgen soll, entnommen werden.

Für das präventive Abschalten im Sinne einer Schutzpegelerhöhung kann als Schaltglied eine Abschalteinrichtung eingesetzt werden. Diese Abschalteinrichtung muss nicht den normativen Anforderungen zum Trennen genügen.

Alternativ erfolgt im Sinne einer Schutzeinrichtung eine sicherere Trennung der Stromquelle durch eine entsprechend der Norm VDE 0100-530 bzw. IEC 60364-5-53 geeignete Schalteinrichtung in Ausführung eines Trennschalters.

Durch die sichere Trennung der Stromquelle in Verbindung mit einer entsprechend der aus der gewählten Strom-Zeit-Kennlinie ausreichenden Auslösezeit ist der Schutz gegen elektrischen Schlag gewährleistet.

Mit Vorteil wird die Gesamtkörperimpedanz als vektorielle Summe einer einstellbaren Körperinnenimpedanz und einer einstellbaren Hautimpedanzen gebildet.

Die elektrischen Impedanzen des menschlichen Körpers bestehen im Wesentlichen aus der Körperinnenimpedanz und Hautimpedanzen, die zusammen die Gesamtkörperimpedanz ergeben. Für die Berechnung des komplexen Berührungsstromes kann als Betrag der Gesamtkörperimpedanz ein in der Norm IEC 60479-1 angegebener Wert einstellbar implementiert werden, vorzugsweise ein variabler Wert zwischen 0.5kΩ und 2kΩ, und in einem "worst-case"-Szenario mit dem niedrigsten Wert gerechnet werden.

Die entsprechenden Verfahrensschritte des erfindungsgemäßen Verfahrens werden durch die strukturellen Merkmale der erfindungsgemäßen Impedanzüberwachungseinrichtung nach Anspruch 5 umgesetzt. Somit treffen die mit dem

Verfahren erzielten technischen Wirkungen und die daraus resultierenden Vorteile gleichermaßen auch auf die Impedanzüberwachungseinrichtung zu.

Dazu ist die Impedanzüberwachungseinrichtung ausgestattet mit einer Messeinrichtung zum gleichzeitigen Messen einer komplexen Impedanz gegenüber Erde für jeden aktiven Leiter, mit einer Recheneinheit, die ausgelegt ist zum Berechnen eines komplexen Berührungsstroms für jeden aktiven Leiter, der nach Auftreten eines ersten Isolationsfehlers an einem der aktiven Leiter (L1, L2, L3) bei einer Berührung eines anderen aktiven Leiters (L1, L2, L3) fließen würde, als Quotient aus einer Leiter-Erde-Spannung des jeweiligen Leiters und einer komplexen Gesamtimpedanz (Zges), die sich aus einer Kombination aus Parallelschaltung und Reihenschaltung der komplexen Impedanzen ergibt, wobei eine Gesamtkörperimpedanz zu der komplexen Impedanz desjenigen aktiven Leiters parallel geschaltet wird, der durch den Mensch berührt wird, zum Prüfen, ob der jeweilige komplexe Berührungsstrom einen einstellbaren Körperstrom-Schwellwert überschreitet und zum Erzeugen eines Schaltsignals bei einer Überschreitung des Körperstrom-Schwellwertes, und mit einem Schaltglied, welches zum Abschalten oder Trennen der Stromquelle mit dem Schaltsignal angesteuert wird.

Die Messeinrichtung ist mit einem jeweiligen Ankopplungszweig zwischen jeden der aktiven Leiter und Erde geschaltet. Das gleichzeitige Messen der jeweiligen komplexen Impedanz erfolgt mittels eines aktiven Messverfahrens, bei dem eine Messspannung dem Netz überlagert wird. Die jeweiligen leiterbezogenen Messkreise führen dabei über die jeweiligen aktiven Leiter des ungeerdeten Stromversorgungssystems, über deren komplexe Impedanzen gegen Erde - bestehend aus dem realen, ohmschen Anteil und dem imaginären, kapazitiven Anteil - und über die Erdleitung der Körper der angeschlossenen Verbraucher zurück in den jeweiligen Ankopplungszweig der Messeinrichtung. Der sich einstellende Messstrom wird für jeden aktiven Leiter über einen Spannungsabfall an einem Messwiderstand erfasst und zur Bestimmung der komplexen Impedanzen ausgewertet.

Die Impedanzüberwachungseinrichtung weist weiterhin eine Recheneinheit auf, die aus der Leiter-Erde-Spannung des jeweiligen Leiters und der Parallelschaltung der komplexen Impedanzen nach dem ohmschen Gesetz für jeden aktiven Leiter einen komplexen Berührungsstrom bestimmt. Dabei wird die Gesamtkörperimpedanz zu der komplexen Impedanz desjenigen aktiven Leiters addiert, mit dem der menschliche Körper in Berührung tritt.

Der so für jeden aktiven Leiter ermittelte komplexe Berührungsstrom wird in der Recheneinheit daraufhin geprüft, ob eine Überschreitung eines personengefährdenden, einstellbaren Körperstrom-Schwellwertes vorliegt. Falls eine solche Überschreitung festgestellt wird, erzeugt die Recheneinheit ein Schaltsignal, um ein Schaltglied zum Abschalten oder Trennen der Stromquelle mit dem Schaltsignal anzusteuern.

Bevorzugt ist in der Recheneinheit eine Strom-Zeit-Kennlinie hinterlegt, welche eine Dauer des Körperstroms über der Höhe des Körperstroms darstellt und aus der der Körperstrom-Schwellwert entnommen wird.

In der Recheneinheit ist eine an die elektrischen Eigenschaften des zu überwachenden ungeerdeten Stromversorgungssystems sowie in Abhängigkeit des gewählten Körperstrommodells einstellbare Strom-Zeit-Kennlinie implementiert, aus der ein dem Schutzziel entsprechender Körperstrom-Schwellwert entnommen wird.

Vorzugsweise wird als Strom-Zeit-Kennlinie einer der in der Norm IEC-60479-1 in Fig. 20 dargestellten Verläufe verwendet.

Die personengefährdende physiologische Wirkung eines berechneten komplexen Berührungsstromes und der einzustellende Körperstrom-Schwellwert sind aus den in der Norm-IEC-60479-1 in Fig. 20 dargestellten Bereichsgrenzen und Grenzlinien ersichtlich und werden als Bewertungsmaßstab bei der Prüfung der berechneten komplexen Berührungsströme übernommen.

Weiterhin weist die Impedanzüberwachungseinrichtung eine Abschalteinrichtung als Schaltglied auf zum präventiven Abschalten der Stromquelle, falls eine Überschreitung des Körperstrom-Schwellwertes erkannt wird.

Soll die Stromquelle nach einem ersten Isolationsfehler präventiv abgeschaltet werden, wird eine Abschalteinrichtung als Schaltglied eingesetzt. Eine derartige Abschalteinrichtung als präventive Maßnahme muss nicht die in der Norm VDE 0100-530 bzw. IEC 60364-5-53 aufgeführten Anforderungen an eine Trennung erfüllen.

Alternativ weist die Impedanzüberwachungseinrichtung einen Trennschalter als Schaltglied zum normgerechten Trennen der Stromquelle auf. In dieser Ausgestaltungsvariante wird aus Gründen der Sicherheit die Stromversorgung von allen Abschnitten oder von einzelnen Abschnitten der elektrischen Anlage unterbrochen, indem die elektrische Stromquelle abgetrennt wird.

Bevorzugt ist die Recheneinheit ausgelegt zur Implementierung einer Gesamtkörperimpedanz, welche als vektorielle Summe der Körperinnenimpedanz und der Hautimpedanzen gebildet wird.

Dabei können unterschiedliche Körperstrommodelle mit unterschiedlichen Widerstandswerten für den menschlichen Körper in der Recheneinheit hinterlegt sein.

Weitere vorteilhafte Ausgestaltungsmerkmale ergeben sich aus der nachfolgenden Beschreibung und der Zeichnung, die eine bevorzugte Ausführungsform der Erfindung anhand eines Beispiels erläutert.

Die **Figur** zeigt eine erfindungsgemäße Impedanzüberwachungseinrichtung 10 für ein ungeerdetes Stromversorgungssystem 2.

In einem funktionalen Blockdiagramm dargestellt ist eine erfindungsgemäße Impedanzüberwachungseinrichtung 10 für eine dreiphasiges, ungeerdetes Stromversorgungssystem 2 (IT-System), in welchem eine Stromquelle 4 über mit Überstromsicherungen F1, F2, F3 abgesicherte aktive Leiter L1, L2, L3 einen Verbraucher 6 speist. Das Stromversorgungssystem 2 ist für den jeweiligen aktiven Leiter L1, L2, L3 durch die ohmschen Isolationswiderstände R1, R2, R3 und die Ableitkapazitäten C1, C2, C3 charakterisiert, welche den Realteil und den Imaginärteil der jeweiligen leiterspezifischen, komplexen Impedanz Z1, Z2, Z3 bilden.

Die Impedanzüberwachungseinrichtung 10 weist eine Messeinrichtung 12 auf, die für jeden aktiven Leiter L1, L2, L3 einen Ankopplungszweig (hier nur einfach dargestellt) zwischen dem jeweiligen aktiven Leiter L1, L2, L3 und Erde PE umfasst. Der Ankopplungszweig wiederum umfasst einen Ankopplungswiderstand Ri, einen Messspannungsgenerator G - der auch gemeinsam für alle drei Ankopplungszweig ausgeführt sein kann - und einem Messwiderstand Rm.

Über die an dem Messwiderstand Rm erfasste Spannung wird in einer Recheneinheit 14 zunächst für jeden aktiven Leiter L1, L2, L3 die jeweilige komplexe Impedanz Z1, Z2, Z3 berechnet.

Zur Bestimmung eines komplexen Berührungsstroms I1, I2, I3 ist in der Recheneinheit 14 ein Körperstrommodell 16 mit einer einstellbaren Gesamtkörperimpedanz Zk hinterlegt. Die berechnete komplexe Impedanz Z1 oder Z2 oder Z3 desjenigen Leiters, mit dem der menschliche Körper in Berührung kommt, wird um den Wert der Gesamtkörperimpedanz Zk verringert (Parallelschaltung der Impedanzen). Mit der Leiter-Erde-Spannung UL1_E, UL2_E, UL3_E des jeweiligen Leiters L1, L2, L3 und einer komplexen Gesamtimpedanz Zges kann gemäß dem ohmschen Gesetz der jeweilige komplexe Berührungsstrom I1, I2, I3 berechnet werden. Dabei ergibt sich die komplexe Gesamtimpedanz Zges aus einer Kombination aus Parallelschaltung und Reihenschaltung der komplexen Impedanzen Z1, Z2, Z3, wobei zu der betreffenden komplexen Impedanz Z1 oder Z2 oder Z3 die Gesamtkörperimpedanz Zk parallel geschaltet wird.

Im Fall der Berührung des aktiven Leiters L3 folgt für den komplexen Berührungsstrom I3

$$I3 = UL3\_E/Zges$$

mit

$$Zges = (Z1 \| Z2) + (Z3 \| Zk).$$

Anschließend erfolgt ein Bewerten des jeweiligen komplexen Berührungsstroms I1, I2, I3 auf der Grundlage einer in der Recheneinheit hinterlegten Strom-Zeit-Kennlinie 18. Dabei findet für jeden komplexen Berührungsstrom I1, I2, I3 eine Prüfung statt, ob dieser einen Körperstrom-Schwellwert überschreitet.

Bei Überschreiten eines aus der Strom-Zeit-Kennlinie 18 entnommenen personengefährdenden, einstellbaren Körperstrom-Schwellwertes wird ein Schaltsignal 20 erzeugt sobald eine Überschreitung erkannt wird.

Das Schaltsignal 20 steuert ein als Abschalteinrichtung oder als Trennschalter ausgeführtes Schaltglied 22 an, welches die Abschaltung der Stromquelle 4 oder gemäß der Norm VDE 0100-530 bzw. IEC 60364-5-53 die sichere Trennung der Stromquelle 4 bewirkt.

Weiterhin vereinfacht dargestellt sind der Fall A des direkten Berührens, bei dem es zu einem direkten Kontakt zwischen dem menschlichen Körper und einem der spannungsführenden aktiven Leiter L1, L2, L3 kommt sowie der Fall B des indirekten Berührens, bei dem eine Gefährdung auftritt, wenn durch einen Isolationsfehler eine elektrische Spannung an Teilen der elektrischen Anlage liegt, beispielsweise einem Motorgehäuse, die unter normalen Betriebsbedingungen spannungsfrei sind (Körperschluss).

**Patentansprüche**

1. Verfahren zur Impedanzüberwachung für ein ein- oder mehrphasiges, ungeerdetes Stromversorgungssystem (2) mit einer Stromquelle (4), aktiven Leitern (L1, L2, L3) und einem Verbraucher (6), umfassend die Verfahrensschritte:

   Messen einer komplexen Impedanz (Z1, Z2, Z3) gegenüber Erde (PE) gleichzeitig für jeden aktiven Leiter (L1, L2, L3) mittels einer Messeinrichtung (12),
   Mittels einer Recheneinheit (14) Berechnen eines komplexen Berührungsstroms (I1, I2, I3) für jeden aktiven Leiter (L1, L2, L3), der nach Auftreten eines ersten Isolationsfehlers an einem der aktiven Leiter (L1, L2, L3) bei einer Berührung eines anderen aktiven Leiters (L1, L2, L3) fließen würde, als Quotient aus einer Leiter-Erde-Spannung (UL1_E, UL2_E, UL3_E) des jeweiligen Leiters (L1, L2, L3) und einer komplexen Gesamtimpedanz (Zges), die sich aus einer Kombination aus Parallelschaltung und Reihenschaltung der komplexen Impedanzen (Z1, Z2, Z3) ergibt,
   wobei eine Gesamtkörperimpedanz (Zk) zu der komplexen Impedanz (Z1, Z2, Z3) desjenigen aktiven Leiters (L1, L2, L3) parallel geschaltet wird, der durch den Mensch berührt wird,
   Prüfen in der Recheneinheit (14), ob der jeweilige komplexe Berührungsstrom (I1, I2, I3) einen einstellbaren Körperstrom-Schwellwert überschreitet,
   Erzeugen eines Schaltsignals (20) in der Recheneinheit (14) bei einer Überschreitung des Körperstrom-Schwellwertes,
   Ansteuern eines Schaltgliedes (22) mit dem Schaltsignal (20) zum Abschalten oder Trennen der Stromquelle (4).

2. Verfahren nach Anspruch 1,
   **dadurch gekennzeichnet,**
   **dass** der Körperstrom-Schwellwert einer implementierten Strom-Zeit-Kennlinie (18) entnommen wird, welche eine Dauer des Körperstroms über der Höhe des Körperstroms darstellt.

3. Verfahren nach Anspruch 2,
   **dadurch gekennzeichnet,**
   **dass** als Strom-Zeit-Kennlinie (18) einer der in der Norm IEC 60479-1 in Fig. 20 dargestellte Verläufe verwendet wird.

4. Verfahren nach einem der Ansprüche 1 bis 3,
   **dadurch gekennzeichnet,**
   **dass** die Gesamtkörperimpedanz (Zk) als vektorielle Summe einer einstellbaren Körperinnenimpedanz und einer einstellbaren Hautimpedanzen gebildet wird.

5. Impedanzüberwachungseinrichtung für ein ein- oder mehrphasiges, ungeerdetes Stromversorgungssystem (2) mit einer Stromquelle (4), aktiven Leitern (L1, L2, L3) und einem Verbraucher (6),

   mit einer Messeinrichtung (12) zum gleichzeitigen Messen einer komplexen Impedanz (Z1, Z2, Z3) gegenüber Erde (PE) für jeden aktiven Leiter (L1, L2, L3),
   mit einer Recheneinheit (14), die ausgelegt ist zum Berechnen eines komplexen Berührungsstroms (I1, I2, I3) für jeden aktiven Leiter (L1, L2, L3), der nach Auftreten eines ersten Isolationsfehlers an einem der aktiven Leiter (L1, L2, L3) bei einer Berührung eines anderen aktiven Leiters (L1, L2, L3) fließen würde, als Quotient aus einer Leiter-Erde-Spannung (UL1_E, UL2_E, UL3_E) des jeweiligen Leiters (L1, L2, L3) und einer komplexen Gesamtimpedanz (Zges), die sich aus einer Kombination aus Parallelschaltung und Reihenschaltung der komplexen Impedanzen (Z1, Z2, Z3) ergibt, wobei eine Gesamtkörperimpedanz (Zk) zu der komplexen Impedanz (Z1, Z2, Z3) desjenigen aktiven Leiters (L1, L2, L3) parallel geschaltet wird, der durch den Mensch berührt wird, zum Prüfen, ob der jeweilige komplexe Berührungsstrom (I1, I2, I3) einen einstellbaren Körperstrom-Schwellwert überschreitet und zum Erzeugen eines Schaltsignals (20) bei einer Überschreitung des Körperstrom-Schwellwertes, und

mit einem Schaltglied (22), welches zum Abschalten oder Trennen der Stromquelle mit dem Schaltsignal (20) angesteuert wird.

6. Impedanzüberwachungseinrichtung nach Anspruch 5,
   **dadurch gekennzeichnet,**
   **dass** die Recheneinheit (14) ausgelegt ist, den Körperstrom-Schwellwert einer implementierten Strom-Zeit-Kennlinie (18) zu entnehmen, welche eine Dauer des Körperstroms über der Höhe des Körperstroms darstellt.

7. Impedanzüberwachungseinrichtung nach Anspruch 6,
   **dadurch gekennzeichnet,**
   **dass** die Recheneinheit (14) ausgelegt ist, als Strom-Zeit-Kennlinie (18) einen der in der Norm IEC 60479-1 in Fig. 20 dargestellten Verläufe zu verwenden.

8. Impedanzüberwachungseinrichtung nach einem der Ansprüche 5 bis 7,
   **gekennzeichnet durch,**
   eine Abschalteinrichtung als Schaltglied (22) zum präventiven Abschalten der Stromquelle (4).

9. Impedanzüberwachungseinrichtung nach einem der Ansprüche 5 bis 7,
   **gekennzeichnet durch**
   einen Trennschalter als Schaltglied (22) zum normgerechten Trennen der Stromquelle.

10. Impedanzüberwachungseinrichtung nach einem der Ansprüche 5 bis 9,
    **dadurch gekennzeichnet,**
    **dass** die Recheneinheit (14) ausgelegt ist zur Implementierung der Gesamtkörperimpedanz (Zk), welche als vektorielle Summe der Körperinnenimpedanz und der Hautimpedanzen gebildet wird.

**Claims**

1. A method for impedance monitoring for a single-phase or multiphase, ungrounded power supply system (2) having a power source (4), active conductors (L1, L2, L3) and a consumer (6), the method comprising the following steps:

   measuring a complex impedance (Z1, Z2, Z3) against ground (PE) for each active conductor (L1, L2, L3) simultaneously using a measuring device (12),
   computing a complex touch current (I1, I2, I3), which would flow upon a touching of another active conductor (L1, L2, L3) after a first insulation fault has arisen at one of the active conductors (L1, L2, L3), for each active conductor (L1, L2, L3) using a computing unit (14) as a quotient from a conductor-to-ground voltage (UL1_E, UL2_E, UL3_E) of the corresponding conductor (L1, L2, L3) and a complex total impedance ($Z_{ges}$), which results from a combination of parallel connection and series connection of the complex impedances (Z1, Z2, Z3), a total-body impedance (Zk) being switched parallel to the complex impedance (Z1, Z2, Z3) of that active conductor (L1, L2, L3) which is touched by the person,
   testing in the computing unit (14) whether the corresponding complex touch current (I1, I2, I3) exceeds a settable body-current threshold value,
   generating a switch signal (20) in the computing unit (14) upon the body-current threshold value being exceeded,
   controlling a switch element (22) using the switch signal (20) for shutting off or isolating the power source (4).

2. The method according to claim 1,
   **characterized in that**
   the body-current threshold value is derived from an implemented current-time characteristic curve (18) which represents a duration of the touch current over the level of the body current.

3. The method according to claim 2,
   **characterized in that**
   one of the shapes shown in Fig. 20 of standard IEC 60479-1 is used as the current-time characteristic curve (18).

4. The method according to any one of the claims 1 to 3,
   **characterized in that**
   the total-body impedance (Zk) is constituted as the vectorial sum of a settable body inner impedance and a settable skin impedance.

5. An impedance monitoring device for a single-phase or multiphase, ungrounded power supply system (2) having a power source (4), active conductors (L1, L2, L3) and a consumer (6),

the impedance monitoring device having a measuring device (12) for simultaneously measuring a complex impedance (Z1, Z2, Z3) against ground (PE) for each active conductor (L1, L2, L3),

the impedance monitoring device having a computing unit (14) which is configured

for computing a complex touch current (I1, I2, I3), which would flow upon a touching of another active conductor (L1, L2, L3) after a first insulation fault has arisen at one of the active conductors (L1, L2, L3), for each active conductor (L1, L2, L3) as a quotient from a conductor-to-ground voltage (UL1_E, UL2_E, UL3_E) of the corresponding conductor (L1, L2, L3) and a complex total impedance ($Z_{ges}$), which results from a combination of parallel connection and series connection of the complex impedances (Z1, Z2, Z3), a total-body impedance (Zk) being switched parallel to the complex impedance (Z1, Z2, Z3) of that active conductor which is touched by the person,

for testing whether the corresponding complex touch current (I1, I2, 13) exceeds a settable body-current threshold value and for generating a switch signal (20) upon the body-current threshold value being exceeded,

the impedance monitoring device having a switch element (22) which is controlled for shutting off or isolating the power source using the switch signal (20).

6. The impedance monitoring device according to claim 5,
**characterized in that**
the computing unit (14) is configured for deriving the body-current threshold value of an implemented current-time characteristic curve (18) which represents a duration of the body current over the level of the body current.

7. The impedance monitoring device according to claim 6,
**characterized in that**
the computing unit is configured to use one of the shapes represented in Fig. 20 of standard IEC 60479-1 as the current-time characteristic curve (18).

8. The impedance monitoring device according to any one of the claims 5 to 7,
**characterized by**
a shut-off device as a switch element (22) for preventively shutting off the power source (4).

9. The impedance monitoring device according to any one of the claims 5 to 7,
**characterized by**
an isolator as a switch element (22) for standardized isolation of the power source.

10. The impedance monitoring device according to any one of the claims 5 to 9,
**characterized in that**
the computing unit (14) is configured for implementing the total-body impedance (Zk) which is formed as the vectorial sum of the body inner impedance and the skin impedance.

**Revendications**

1. Procédé pour la surveillance d'impédance pour un système d'alimentation en courant (2) monophasé ou polyphasé non mis à la terre ayant une source d'alimentation (4), des conducteurs actifs (L1, L2, L3) et un consommateur (6), le procédé comprenant les étapes suivantes :

la mesure d'une impédance complexe (Z1, Z2, Z3) par rapport à la terre (PE) pour chaque conducteur actif (L1, L2, L3) simultanément à l'aide d'un dispositif de mesure (12),
le calcul d'un courant de contact complexe (I1, I2, I3), qui circulerait lors d'un contact avec un autre conducteur actif (L1, L2, L3) après qu'une première faute d'isolement se soit produite au niveau de l'un des conducteurs actifs (L1, L2, L3), pour chaque conducteur actif (L1, L2, L3) à l'aide d'une unité de calcul (14) sous forme de quotient d'une tension (UL1_E, UL2_E, UL3_E) entre le conducteur et la terre à partir du conducteur correspondant (L1, L2, L3) et à partir d'une impédance totale complexe (Zges), qui résulte d'une combinaison de montage en parallèle et de montage en série des impédances complexes (Z1, Z2, Z3), une impédance totale (Zk) du corps humain étant commutée en parallèle à l'impédance complexe (Z1, Z2, Z3) de ce conducteur actif (L1, L2, L3) qui est touché par la personne,
la vérification dans l'unité de calcul (14) si le courant de contact complexe (I1, I2, I3) correspondant dépasse un seuil de courant du corps humain réglable,
la génération d'un signal de commutation (20) dans l'unité de calcul (14) lorsque le seuil de courant du corps humain est dépassé,
la commande d'un élément de commutation (22) à l'aide du signal de commutation (20) pour couper ou isoler la source d'alimentation (4).

**2.** Procédé selon la revendication 1, **caractérisé en ce que** le seuil de courant du corps humain est dérivé d'une courbe caractéristique courant/temps (18) mise en œuvre qui représente une durée du courant de contact au-dessus du niveau du courant du corps humain.

**3.** Procédé selon la revendication 2, **caractérisé en ce que** l'une des courbes représentées sur la figure 20 de la norme CEI 60479-1 est utilisée comme courbe caractéristique courant/temps (18).

**4.** Procédé selon l'une quelconque des revendications 1 à 3, **caractérisé en ce que** l'impédance totale (Zk) du corps humain est constituée comme la somme vectorielle d'une impédance interne du corps humain réglable et d'une impédance de la peau réglable.

**5.** Dispositif de surveillance d'impédance pour un système d'alimentation en courant (2) monophasé ou polyphasé non mis à la terre ayant une source d'alimentation (4), des conducteurs actifs (L1, L2, L3) et un consommateur (6),

le dispositif de surveillance d'impédance ayant un dispositif de mesure (12) pour mesurer simultanément une impédance complexe (Z1, Z2, Z3) par rapport à la terre (PE) pour chaque conducteur actif (L1, L2, L3),
le dispositif de surveillance d'impédance ayant une unité de calcul (14) qui est configurée
pour calculer un courant de contact complexe (I1, I2, I3), qui circulerait lors d'un contact avec un autre conducteur actif (L1, L2, L3) après qu'une première faute d'isolement se soit produite au niveau de l'un des conducteurs actifs (L1, L2, L3), pour chaque conducteur actif (L1, L2, L3) sous forme d'un quotient à partir d'une tension (UL1_E, UL2_E, UL3_E) entre le conducteur et la terre du conducteur correspondant (L1, L2, L3) et à partir d'une impédance totale complexe ($Z_{ges}$), qui résulte d'une combinaison de montage en parallèle et de montage en série des impédances complexes (Z1, Z2, Z3), une impédance totale du corps humain (Zk) étant commutée en parallèle à l'impédance complexe (Z1, Z2, Z3) de ce conducteur actif qui est touché par la personne,
pour vérifier si le courant de contact complexe (I1, I2, I3) correspondant dépasse un seuil de courant du corps humain réglable et pour générer un signal de commutation (20) lorsque le seuil de courant du corps humain est dépassé,
le dispositif de surveillance d'impédance ayant un élément de commutation (22) qui est commandé pour couper ou isoler la source d'alimentation à l'aide du signal de commutation (20).

**6.** Dispositif de surveillance d'impédance selon la revendication 5, **caractérisé en ce que** l'unité de calcul (14) est configurée pour dériver le seuil de courant du corps humain d'une courbe caractéristique courant/temps (18) mise en œuvre qui représente une durée du courant du corps humain au-dessus du niveau du courant du corps humain.

**7.** Dispositif de surveillance d'impédance selon la revendication 6, **caractérisé en ce que** l'unité de calcul est configurée pour utiliser l'une des courbes représentées sur la figure 20 de la norme CEI 60479-1 comme courbe caractéristique courant/temps (18).

**8.** Dispositif de surveillance d'impédance selon l'une quelconque des revendications 5 à 7, **caractérisé par** un dispositif de coupure comme élément de commutation (22) pour couper préventivement la source d'alimentation (4).

**9.** Dispositif de surveillance d'impédance selon l'une quelconque des revendications 5 à 7, **caractérisé par** un isolateur comme élément de commutation (22) pour l'isolation normalisée de la source d'alimentation.

**10.** Dispositif de surveillance d'impédance selon l'une quelconque des revendications 5 à 9, **caractérisé en ce que** l'unité de calcul (14) est configurée pour mettre en œuvre l'impédance totale (Zk) du corps humain qui est formée comme la somme vectorielle de l'impédance interne du corps humain et de l'impédance de la peau.

Fig.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014204038 A1
- EP 3832324 A1
- EP 3598151 A1
- EP 0061704 B1
- US 7538454 B2